# EUROPEAN PATENT APPLICATION

(11) **EP 3 366 456 A1**
(43) Date of publication of application: **29.08.2018**
(21) Application number: 16857396.2
(22) Date of filing: 17.10.2016
(51) Int. Cl.: B29C 59/02, B41M 1/12, B41M 1/30, B41M 5/52

(54) **SURFACE STRUCTURE FOR PRINTING BASE MATERIAL, AND METHOD FOR MANUFACTURING SAME**

(30) Priority: 22.10.2015 JP 2015208004
(71) Applicant: National Institute of Advanced Industrial Science and Technology, Tokyo 100-8921 (JP)
(72) Inventor: HOKARI Ryohei, Tsukuba-shi Ibaraki 305-8564 (JP); KURIHARA Kazuma, Tsukuba-shi Ibaraki 305-8564 (JP); TAKADA Naoki, Tsukuba-shi Ibaraki 305-8564 (JP)
(74) Representative: Hoffmann Eitle
(86) International application number: PCT/JP2016/080676
(87) International publication number: WO 2017/069081

(57) **Abstract**

In the present invention, an uneven structure is formed on a surface of a base material to be printed to which ink is applied, and the pitch, the shape in plan view, and the depth of recesses in the uneven structure are determined on the basis of the physical properties (specific weight, viscosity, and contact angle) of ink to be used, in accordance with a printing pattern and a required printing precision. The amount of ink filling the recesses is thereby controlled, and high-precision is enabled at low cost without changing the printing process itself.

## Description

### Technical Field

The present invention relates to a base material on which printing is to be performed on the surface thereof, in other words, a base material to be printed, and particularly to a surface structure for the base material to be printed for use in high-precision printing requiring line-width equalization, a high resolution, and a high aspect ratio and a method for manufacturing the same.

### Background Art

As general printing methods, relief printing, intaglio printing, lithographic printing, inkjet printing, stencil printing, and the like are widely known. As a printing method enabling higher-precision printing, offset printing using wettability is known.

On the other hand, there is known a method for manufacturing a pattern sheet having a coating layer patterned by forming a hydrophilic/water-repellent pattern composed of a hydrophilic portion and a water-repellent portion on the surface of the base material to be printed and applying a coating liquid to the hydrophilic portion and then solidifying the coating liquid.

The combination of the hydrophilic portion and the water-repellent portion enables high-precision printing and therefore it has been developed not only in printed electronics such as a touch panel or a solar battery, but also in applications to a decorating technique for home electric appliances or the like and to an optical element.

Patent Documents 1 to 3 suggest various methods for obtaining a hydrophilic/water-repellent pattern on the surface of a base material.

### Citation List

### Patent Document

Patent Document 1: Japanese Patent Application Laid-Open No. 2000-87016
Patent Document 2: Japanese Patent Application Laid-Open No. 2000-282240
Patent Document 3: Japanese Patent Application Laid-Open No. 2000-223270

### Non-Patent Document

### Summary

### Technical Problem

The printing method using the water-repellent or hydrophilic surface pattern, however, has a limitation in implementing high-precision. For example, the control of a base material for which wettability is partially changed by light irradiation, corona treatment, or plasma treatment depends on a light condensed size or a mask size. Therefore, it is difficult to implementing high precision of a size of 1 µm or less.

Moreover, to control the surface wettability by transferring and molding a fine uneven structure on the surface of a base material or a sheet-like material, an aggregation of fine uneven structures is necessary. Therefore, it is difficult to implement miniaturization. For example, while a surface exhibiting water repellency due to a fine uneven structure of a roughness degree of 1 µm or more is obtained in the technique described in Patent Document 1, the water-repellent region functions with an aggregation of unit cells each having a fine uneven structure and therefore the technique requires a region wider than the size of the unit structure.

Also in the case of using a water-repellent material or a hydrophilic material, it is difficult to form a pattern of a water-repellent portion or a hydrophilic portion in a microscopic region. Moreover, to form the pattern in the microscopic region, it is required to employ a method of printing and transferring by using an offset printing method, a microcontact printing method, or the like or a method of selectively removing by using a photolithography method or the like. This leads to a complicated manufacturing process, and moreover it is technically difficult to control the print shape stably at a high resolution.

Furthermore, there is a problem that the aspect ratio of the pattern falls in proportion to the pattern size in forming a fine pattern.

Therefore, it is an object of the present invention to enable high-precision and high-aspect-ratio printing at low cost and without changing the printing process by forming uneven structures on a printed surface of a base material to be printed and controlling the amount of ink filling the recesses.

### Solution to Problem

In order to solve the above problems, the present invention implements high-precision and high-aspect-ratio printing by forming a fine uneven structure on a base material to be printed, locally controlling the surface wettability, and using a liquid printing apparatus such as a screen printing apparatus or an inkjet device.

More specifically, in a base material to be printed according to the present invention, an uneven structure is formed on a surface of the base material to be printed to which ink is applied, and the pitch, the shape in plan view, and the depth of recesses in the uneven structure are determined on the basis of the physical properties (specific weight, viscosity, and contact angle) of ink to be used, in accordance with a printing pattern and a required printing precision, so that the amount of ink filling the recesses is controlled.

In the above, the uneven structure formed on the base material to be printed is formed only in one region of a master mask pattern region that particularly requires high-precision printing, ink such as liquid functional ink discharged from the master mask pattern comes in contact with the uneven structure of the base material to be printed and the ink is sucked by capillary force into between the uneven structures, thereby implementing printing with higher precision and a higher aspect ratio than those of the master mask pattern.

Moreover, in a method of manufacturing a base material to be printed according to the present invention, the above base material to be printed is manufactured by a first step of positioning a substrate; a second step of performing patterning, which is in the negative relationship of the uneven structure of the base material to be printed, on the surface of the substrate; a third step of producing a mold by processing the substrate on the basis of the patterning; a fourth step of applying a release agent such as a fluorine-based release agent on the surface of the mold; a fifth step of pressing a thermoplastic resin sheet against the surface of the mold to transfer the uneven structure formed on the mold; and a sixth step of peeling the thermoplastic resin sheet.

### Advantageous Effects of Invention

According to the present invention, for example, high-resolution printing of 1 µm or less is possible. Furthermore, in the case of adjusting the shape of the uneven structure, the pitch thereof, and the viscosity of functional ink or the like, liquid functional printing of 100 nm or less is enabled.

This printing technique onto the fine uneven structure enables high-resolution printing with a uniform line width and therefore is useful for the development of various fields such as printed electronics, organic electronics, an electrode wiring technique for a solar battery or a touch panel, or the like.

Furthermore, the technique enables the formation of an ink shape having a high aspect ratio, by which a reduction in wiring resistance can be expected. Moreover, the print shape depends on the shape of the fine uneven structure and therefore the printing mask may be a coarsely-produced mask, thereby enabling a reduction in manufacturing cost. Furthermore, particularly in screen printing, the use of a coarse mesh revolves a problem of ink clogging, and therefore it contributes a lot to implementing a high resolution of ink that often causes clogging such as conductive ink or the like

### Brief Description of Drawings

Fig. 1 is a diagram illustrating a case of printing a line of 1 µm width with 100 nm printing precision.
Fig. 2 is a diagram illustrating a case of printing a pattern having fine lines at the minimum 100 nm with 100 nm printing precision.
Fig. 3 is a diagram for schematically describing the behavior of ink in the uneven structure in the case of performing screen printing in accordance with printing processes (1) to (5).
Fig. 4(a) is a diagram illustrating a case of printing two lines of 0.1 mm width, spaced 1 mm apart from each other, on the base material to be printed and Fig. 4(b) is a diagram illustrating a case of printing three lines of 1 µm width, spaced 4 µm apart from each other, on the base material to be printed.
Fig. 5 is a diagram illustrating cross-sectional shapes of an uneven structure: Fig. 5(a) is an example of a rectangular cross section; and Fig. 5(b) is an example of chevron or a bullet-shaped cross section.
Fig. 6 is a diagram illustrating a top shape of uneven structures facing each other: Fig. 6(a) is an example of a linear shape of two parallel horizontal lines; Fig. 6(b) is an example of a doughnut shape; Fig. 6(c) is an example of a crescent shape (arc shape); Fig. 6(d) is an example of a U shape; Fig. 6(e) is an example of an L shape; Fig. 6(f) is an example of a square shape; and Fig. 6(g) is an example of a cross shape.
Fig. 7 is a diagram illustrating a process of transferring an uneven structure to the surface of a sheet and completing printing when printing a circuit pattern previously composed of a plurality of thin lines onto a sheet made of thermoplastic resin with conductive ink.
Fig. 8 is a diagram illustrating a case of performing printing with a plurality of functional inks overlaid: Fig. 8(a) is an example of a case of recoating for one uneven structure; and Fig. 8(b) is an example of a case in which a plurality of uneven structures are overlaid.
Fig. 9 is a diagram illustrating cross-sectional shapes of an uneven structure in the case where a water-repellent layer, a hydrophilic layer, and a base material are stacked.
Fig. 10 is a diagram illustrating an example of combination of uneven structures different from each other.
Fig. 11 is a diagram illustrating surface patterns for a base material to be printed.
Fig. 12 is a diagram illustrating a specific example of screen printing.
Fig. 13 is a diagram illustrating measurement results of a contact angle of water relative to a gap between the formed convex structures.
Fig. 14 is a photomicrograph of a print shape.

### Description of Embodiments

Embodiments of the present invention will be described with reference to appended drawings.

### Embodiments

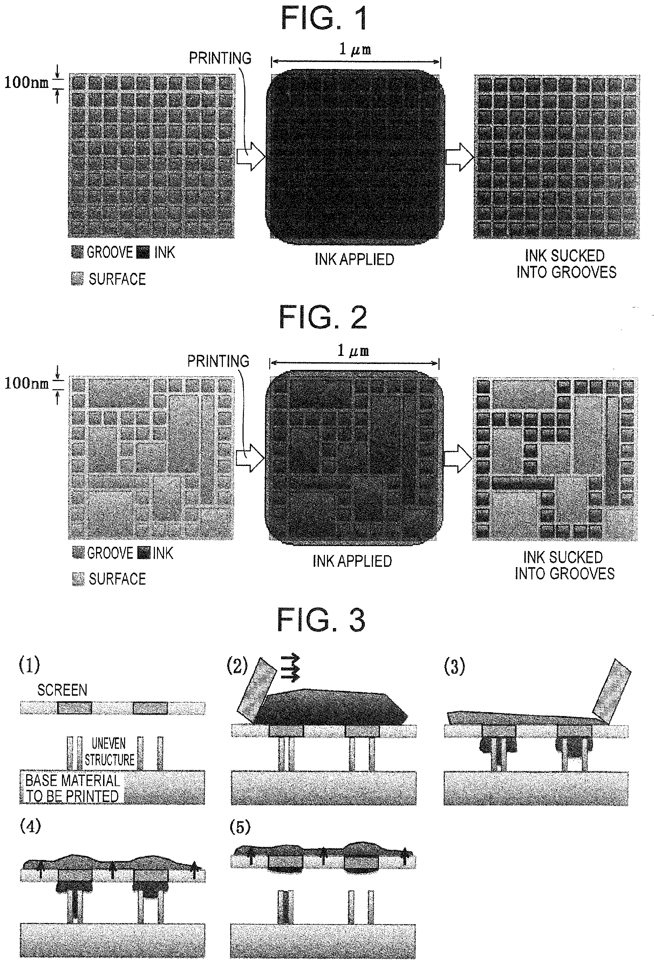

First, the basic principle of the present invention will be described with reference to Figs. 1 to 3.

Figs. 1 and 2 each illustrate an uneven structure formed on the surface of a base material to be printed in order to obtain a printing precision of 100 nm: Fig. 1 illustrates a case of printing a line of 1 µm width; and Fig. 2 illustrates a case of printing a pattern having fine lines at the minimum 100 nm.

In Fig. 1, 100 square recesses are formed with 100 nm pitch per square with a side of 1 µm. In Fig. 2, square recesses of 100 nm width are combined with rectangular recesses of the same width according to a printing pattern.

Fig. 3 is a diagram for schematically describing the behavior of ink in an uneven structure in the case of performing screen printing in accordance with printing processes (1) to (5), wherein the uneven structure formed on the surface of a base material to be printed is illustrated with an extreme size and at an extreme pitch.

The left side of Fig. 3 illustrates a case of an appropriate width (pitch) of a recess and the right side of Fig. 3 illustrates a case of a too wide width.
(1) A slit formed on the screen is aligned with a corresponding recess, which is formed on the corresponding surface of the base material to be printed.
(2) Ink is applied onto the screen completed in alignment and the excess ink is scraped with a squeegee.
(3) Ink enters the recess of the uneven structure, with being pushed into the recess, from the slit formed on the screen, and the ink is pulled into the inside of the recess by a capillary phenomenon and a gravity action due to a capillary force by adjusting the contact angle relative to the recess side wall to 90° or less.
   Specifically, in the case where the contact angle is 90° or less, ink naturally enters the inner part of the recess. In the case where the contact angle exceeds 90°, however, ink is subjected to a force in a direction in which the ink is pushed out before completely filling the recesses due to the surface tension from the side wall. A part of ink that cannot fully enter the recess overflows into the side wall of the projection.
(4) At the start of the peeling process of the screen, ink is drawn to the screen side through the slit of the screen due to the surface tension from the recess side wall when the screen is to be separated away from the projection on the surface of the base material to be printed.
   In this manner, ink enters the surface region of the base material to be printed once, regardless of the pitch of the uneven structure, and then is drawn into the recess due to the capillary force from the side wall of the uneven structure.
(5) At the completion of the peeling process of the screen, all of the excess ink moves to the screen side and the recess on the left side is completely filled with ink. On the other hand, in the recess on the right side, the pitch is too large and therefore the capillary force from the recess side wall does not fully act, by which almost all of the ink is discharged from the recess due to the surface tension and moves to the screen side.

In some cases, however, ink could not be pushed out even if the contact angle is 90° or more due to a gravity effect according to the specific weight of the ink.

In addition, if the viscosity of ink is high, the recess is completely filled with the ink and the printing process ends before ink overflowing the recess is completely pushed out to the top surface of the screen, and therefore a printing pattern with ink remaining in the grooves is obtained.

While the viscosity of ink is desirably in a range of 1000 to 100000 mPa*s, it may be 5 mPa*s or higher and 500000 mPa*s or lower.

In this manner, when the pitch of the uneven structure is small (narrow), the ink in the recess remains due to the function of the capillary force, while the ink in portions other than the recesses (the upper part of the projection, the upper space of the recess, and the like) is less retentive and therefore is drawn to the screen side and removed. On the other hand, when the pitch of the uneven structure is large (wide), the capillary force does not function so much and therefore the ink that has entered the upper region of the groove is also pulled to the screen side and removed. As a result, ink does not remain in the groove.

Specifically, the pitch, depth, and pattern of the recess are optimally combined to meet the physical properties (a specific weight, a viscosity, a surface tension, a contact angle relative to the base material to be printed, a particle diameter of a particle included in ink, and the like) of ink, thereby enabling ink to fill the recess completely and the excess ink to be discharged completely to the top surface of the screen in the printing process and thus enabling locally high-precision printing according to the selection of the uneven structure.

In this manner, the distribution of uneven structures necessary for keeping the ink in the grooves is determined according to a balance among "the surface tension of ink," "a contact angle of ink relative to the base material to be printed," and "the depth and pitch of the uneven structure," which are the main parameters that determine the capillary force, and a balance of a pressure for pressing ink or the discharge amount of the ink.

In an experiment using the same ink, it has been observed that ink remains in the grooves at a pitch of 50 µm or less and that ink does not remain in the grooves at a pitch of 60 µm or more. Moreover, the behavior of ink is able to be further controlled by changing the surface tension, the contact angle, and the viscosity with a temperature control.

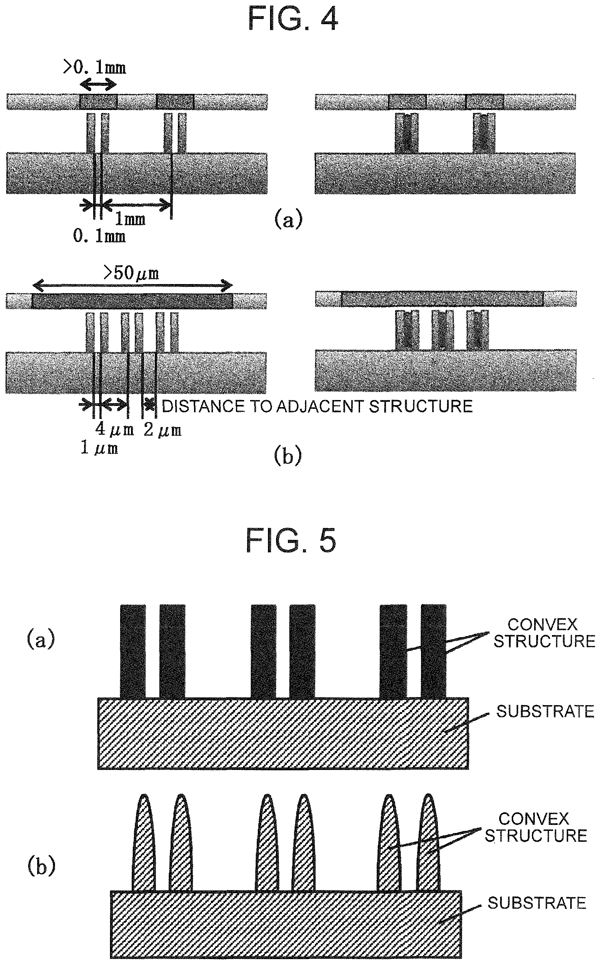

In order to implement high-precision printing, for example, in the case of printing two lines of 0.1 mm width, spaced 1 mm apart from each other, on the base material to be printed, uneven structures each having 0.1 mm groove width are arranged with a distance between the grooves of 1 mm, for example, as illustrated in Fig. 4(a) and the open parts of the screen are aligned thereon before printing. Moreover, in the case of printing three lines of 1 µm width, spaced 4 µm apart from each other, on the base material to be printed, the gap between the three lines is smaller than 50 µm, which is the estimated minimum width of the current screen opening portion, and therefore one opening portion is used as illustrated in Fig. 4(b). Assuming that the distance to the adjacent structure is 2 µm in the above, the threshold value of the pitch of the above uneven structure needs to be controlled to be 1 µm or more and 2 µm or less for printing.

For example, in the case of enabling high-resolution printing of 1 µm or less, the pitch of the adjacent uneven structure is controlled to be 30 nm or more and 100 µm or less and the viscosity of functional ink is adjusted, thereby enabling liquid functional printing of 100 nm or less. The cross-sectional shape of an uneven structure is composed of two convex structures facing each other and may be a rectangle as illustrated in Fig. 5(a) or a chevron or bullet shape as illustrated in Fig. 5(b).

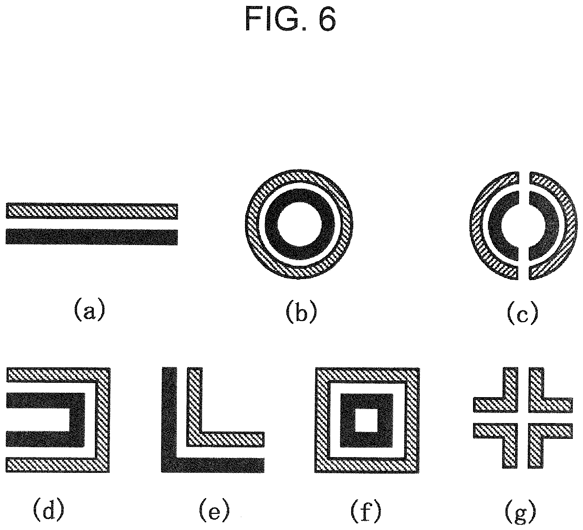

Moreover, the top shape of the uneven structures facing each other only needs to have a structure that they are close to each other. The top shape may be a linear shape of two parallel horizontal lines as illustrated in Fig. 6(a), a doughnut shape as illustrated in Fig. 6(b), a crescent shape (arc shape) as illustrated in Fig. 6(c), a U shape as illustrated in Fig. 6(d), an L shape as illustrated in Fig. 6(e), a square shape as illustrated in Fig. 6(f), a cross shape as illustrated in Fig. 6(g), or an arbitrary combination thereof.

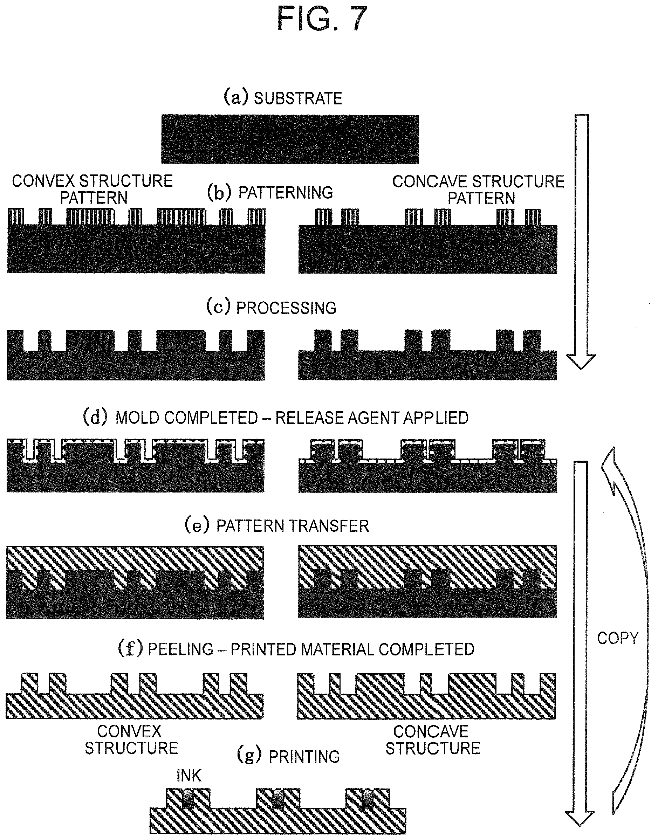

The process of transferring the uneven structure to the sheet surface and completing the printing will be described with reference to Fig. 7, by giving an example of a case where a circuit pattern previously composed of a plurality of thin lines is printed onto a sheet made of thermoplastic resin with conductive ink.
(a) A substrate is positioned. The substrate is desirably made of silicon and may be glass such as quartz or ceramic such as alumina, silicon carbide, or the like, and metal, semiconductor, and dielectric may be deposited on these types of substrate.
(b) The surface of the substrate is patterned in such a way that the patterning is in the negative relationship with the uneven structure of the base material to be printed. Photolithography or electron beam lithography is desirable as a method of the patterning, while laser drawing, a biotemplate, colloidal particles, or the like may be used therefor.
(c) The substrate is processed on the basis of the patterning to produce a mold. Dry etching is desirable for the substrate processing, while wet etching, sandblast, or the like may be employed and metal, semiconductor, and dielectric may be selectively deposited by using a lift-off method. In addition, the process (b) may be omitted, and the substrate in Fig. 7(a) may be directly processed by using dicing, a focused ion beam, a laser, a machining device, or the like to produce the mold. In this case, a copy made by electroforming (plating) may be used as a mold.
(d) A release agent such as a fluorine-based release agent (for example, Optool HD series) is applied to the surface of the completed mold.
(e) The sheet is pressed to the surface of the mold to transfer the pattern. The transfer molding of the pattern is carried out by using a technique such as imprinting (nano-imprinting), injection molding, hot embossing, or forming molding.

As sheet materials, thermosetting resin such as phenolic resin, epoxy resin, melamine resin, urea resin, polyimide, unsaturated polyester resin, diallyl phthalate resin, polyurethane resin, silicone resin, or the like, or ultraviolet (light) curing resin such as radical polymerization type (acrylate, unsaturated polyester) resin, cationic polymerization type (epoxy, oxetane, vinyl ether) resin, or the like may be used.
(f) The sheet is peeled.
(g) The uneven structures transferred to the sheet are aligned with the ink discharge positions of the screen and thereafter printing is performed.

In the case of manufacturing a plurality of base materials to be printed, processes (d) to (f) are repeated.

In this case, continuous production is possible by sequentially feeding a roll of sheet and changing the roll.

Moreover, in the case of color printing, process (g) is repeated by using screens different in the mask pattern according to ink.

Furthermore, in the inkjet printer, square or round uneven structures each having a certain area are formed at a predetermined pitch on the entire printed surface similarly on the basis of the surface tension of ink to be used and a contact angle to the base material to be printed (both are the physical properties of ink), and the initial position of the ink head is aligned with the initial position (alignment mark) of the uneven structures formed on the base material to be printed.

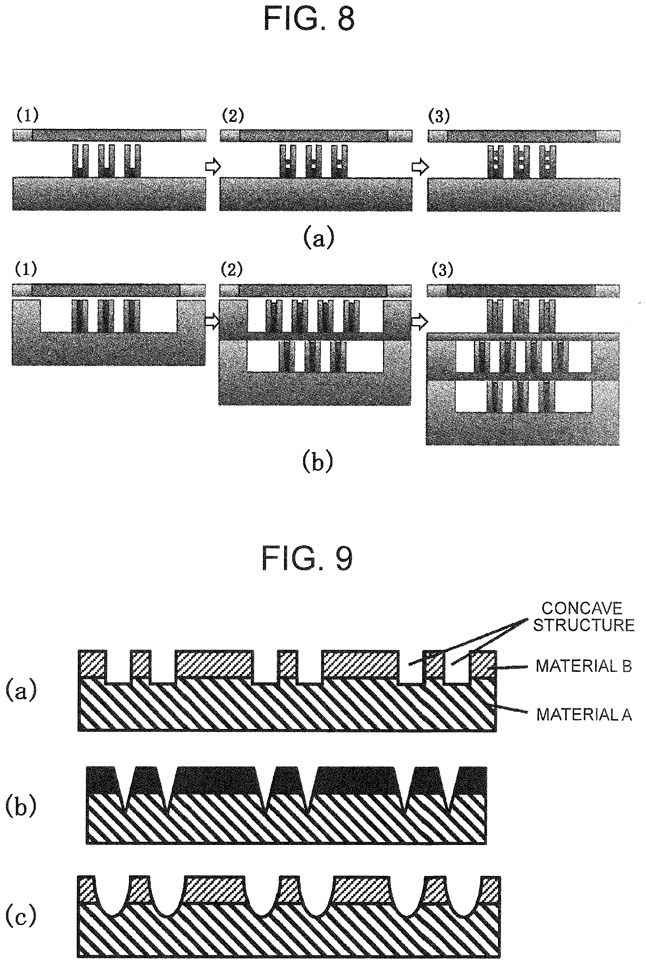

In the case of printing and manufacturing a functional sheet, functional inks such as (1) conductive ink, (2) insulating ink, and (3) organic semiconductor ink may be overlaid for printing as illustrated in Fig. 8(a). Furthermore, after printing with conductive ink containing silver, gold, platinum, copper, or alloy or mixture thereof or with a palladium catalyst, the sheet may also be selectively plated with gold, copper, nickel, or the like to make a functional layer. Furthermore, as illustrated in Fig. 8(b), an uneven structure may be formed on each of a plurality of sheets, different inks are applied thereon, and the uneven structures are sequentially stacked, thereby enabling a three-dimensional functional sheet to be manufactured.

Moreover, in the case where the base material to be printed includes an uneven wettability control layer formed of two or more layers such as a water-repellent layer, a hydrophilic layer, and a base material or such as a hydrophilic layer, a water-repellent layer, and a base material from the surface, an uneven transfer is performed to expose the water-repellent layer or the hydrophilic layer, which is the second layer, and to locally control the wettability, thereby enabling thinning of lines. In this case, the structure does not need to include the uneven structures facing each other, though it is desirable that the structure includes a local concave space formed therein. The cross-sectional shape of the structure in this case may be a groove shape as illustrated in Fig. 9(a), a triangle as illustrated in Fig. 9(b), or a semicircular shape or a cone shape as illustrated in Fig. 9(c).

As the material for the water-repellent layer that can be used in this case, water-repellent resin is the best material. Specifically, it is possible to use fluorine resin, silicone resin, cycloolefin polymer (COP), cyclic olefin copolymer resin (COC), polyethylene, and polyester, though the material may be self-assembled monolayer, dielectric, laser-treated metal, water-repellent metal dry-deposited by vacuum deposition or sputtering, metal nitride, or an alloy material which is a combination thereof.

Furthermore, as the material for the hydrophilic layer, hydrophilic resin is the best material. Specifically, acryl, polycarbonate, polylactic acid, nylon, or the like is the best material, though hydrophilic resin in which a surfactant or antistatic agent is added to resin may be used.

In the case of dry deposition, the effect can be expressed by using titanium oxide, glass material, and alumina material. Therefore, it is possible to use a material in which these hydrophilic materials are added to resin or a coating film. In addition, in the case of using a metal surface, the material may be a hydrophilic metal, metal oxide, or an alloy material which is a combination thereof.

The present invention is applicable not only to screen printing (stencil printing) and inkjet printing, but also to relief printing and offset printing.

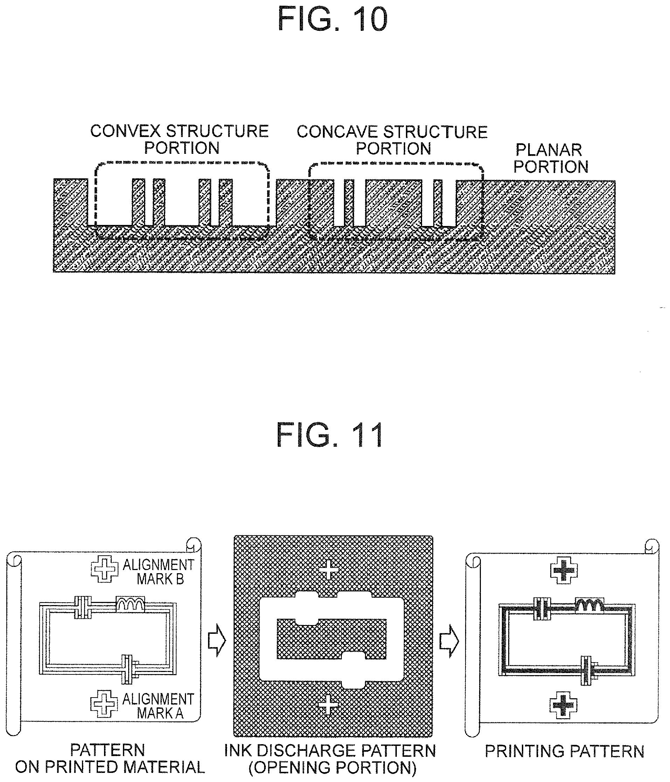

In addition, while it is desirable that convex or concave structures are formed on the entire surface of the base material to be printed, a convex structure, a concave structure, and a plane may be mixed as illustrated in Fig. 10. A combination appropriate for a required printing precision may be employed for a final printing pattern.

Furthermore, it is possible to employ a design system capable of automatically distinguishing between a portion requiring a capillary force and a portion not requiring the capillary force for each region from a necessary line width for a required printing pattern so as to use a convex structure for a portion requiring the capillary force due to a narrow line width, a concave structure for a portion requiring a narrow gap, and a plane for other portions.

Furthermore, for alignment of the base material to be printed with an ink discharge pattern, two or more alignment marks are preferably used as illustrated in Fig. 11. Specifically, a mold is previously patterned with two or more alignment marks, and then the alignment marks are transferred to the base material to be printed simultaneously with the transfer of the uneven structure, and an ink discharge pattern based on the alignment marks is also prepared in advance.

The stage is moved by using an optical microscope, so that the alignment marks A and B of the ink discharge pattern are overlaid on those of the base material to be printed with respect to the vertical, horizontal, and rotational directions. In this process, the printing system desirably has a mechanism capable of controlling the stage of the base material to be printed or the position of the ink discharge pattern. The top shape of the alignment mark is desirably a cross shape or a shape including a vernier scale, and a circle or any other simple shape may be used.

According to the present invention, ink is confined to the inside of the uneven structure due to a capillary force, thereby enabling not only thinning of lines, but also acquisition of a high aspect ratio shape. In addition, the employment of the uneven structure prevents the base material from being easily broken when it is extended and increases the rigidity, thereby improving bending and durability.

In the case of using the base material to be printed as wiring, the cross-sectional area is large, which enables a decrease in resistivity, and the functional ink enters recesses due to a capillary force, thereby preventing the wiring from being easily disconnected in comparison with the conventional printing methods.

In addition, since the bottom and the side wall of ink are covered with a structure, ink is less susceptible to various types of environmental deterioration caused by oxidation or the like, the performance of the functional ink can be maintained for a long time, and printing is independent of whether or not the direction is vertical or parallel to the printing direction, thereby enabling the printing to be performed in either direction in the same manner.

Furthermore, the base material is able to be multilayered or curved in surface by adding a film insert molding process. Thereby, the present invention is expected to be applied not only to electronics such as a touch panel, but also to an optical element or a decorative article using the electromagnetic response characteristics with a metal fine pattern.

Hereinafter, concrete examples will be described.

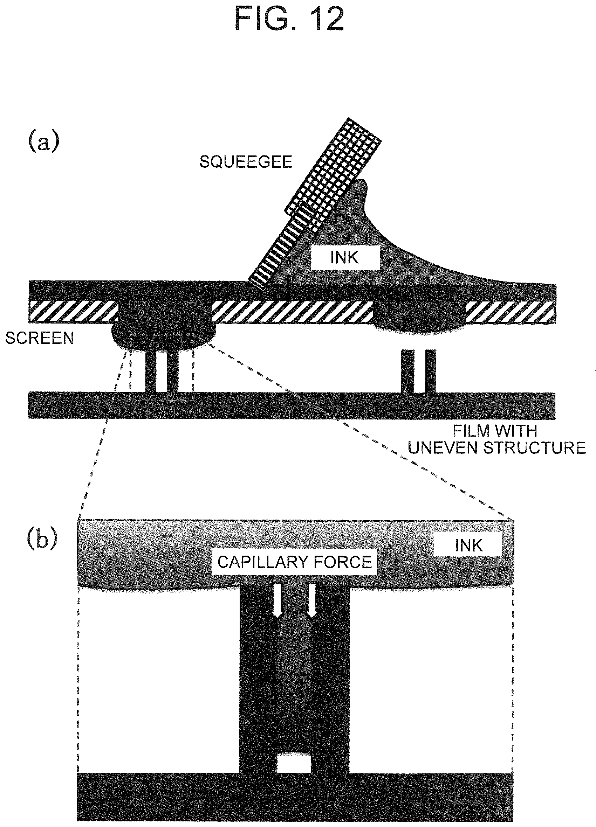

As illustrated in Fig. 12, as a method of controlling a print shape with a uniform line width and excellent resolution, printing was performed on a fine uneven structure by using a screen printing apparatus. The fine uneven structure, which was used in this printing, is one manufactured by transferring a groove shape to ultraviolet curable resin with a Si wafer of 4 inches grooved by dicing as a mold.

The dicing blade width is 13 µm, the center-to-center distance between grooves is at a minimum 20 µm, and the groove depth is 100 µm.

The screen printing plate is a film original plate of 500 meshes, having an opening portion of 100 µm line width. Moreover, a paste of a mixture of carbon and silver was used as ink. The printing conditions are defined such that the clearance is 1.0 mm, the squeegee speed is 28 mm/sec, and the squeegee pressure is 0.17 MPa.

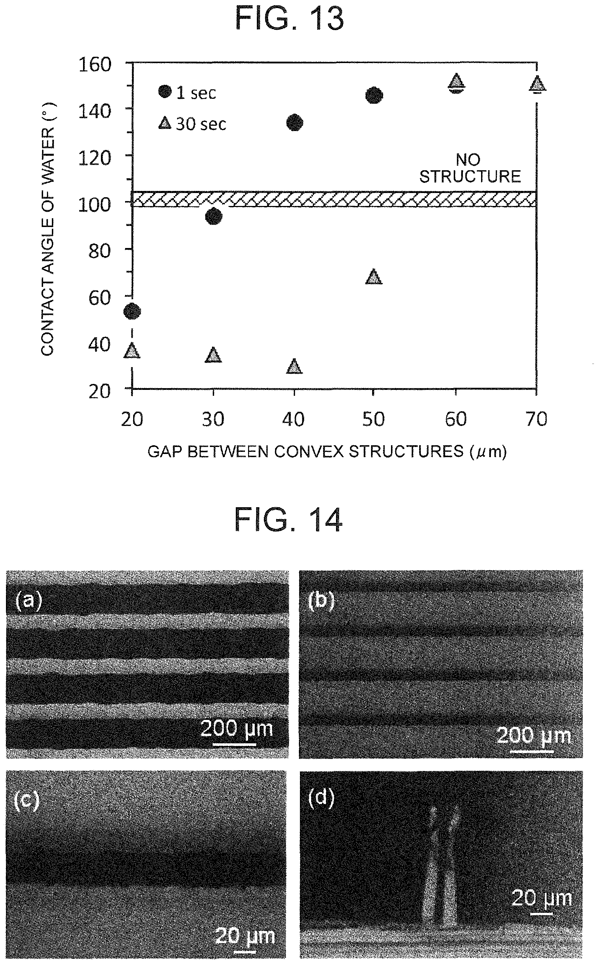

Fig. 13 illustrates the measurement results of a contact angle of water to a gap between the convex structures on the formed structure. The measurement result after 1 sec (black circle) from dropping a droplet and the measurement result after 30 sec (black triangle) therefrom are plotted.

While a contact angle is approx. 100° when no uneven structure is formed, it can be confirmed that the use of uneven structures causes a change from a water-repellent property to a hydrophilic property depending on a gap between the structures.

Specifically, it can be confirmed that the measurement result exhibits a hydrophilic property of 40° or less as a contact angle after 30 sec from dropping a droplet if the gap is 40 µm or less, while the measurement result exhibits a water-repellent property of approx. 150° as a contact angle after 30 sec from dropping a droplet when the gap is 60 µm or more.

Fig. 14 is a photomicrograph of a print shape. Fig. 14(a) illustrates a print shape printed on a plane film without an uneven structure and Figs. 14(b) to 14(d) each illustrate a print shape according to the present invention.

As confirmed from Fig. 14(a), when no uneven structure is formed, the print shape has a line width of approx. 123 to 138 µm for the opening of 100 µm width formed on the screen and the variation is approx. 15 µm due to ink bleed or the like.

On the other hand, in Figs. 14(b) to 14(d), it has been confirmed that the print shape has a line width of approx. 23 to 31 µm under the same printing conditions and that the thinning of lines in the shape is obtained.

Furthermore, the uneven structures prevent the ink bleed and therefore the variation of the line width is approx. 8 µm, by which it has been confirmed that printing has been made with a more uniform line width. In addition, according to the cross-sectional view of Fig. 14(d), it has been observed that ink enters the inside of the grooves and the effect of the surface tension by the uneven structures has been confirmed.

### Industrial Applicability

As described hereinabove, according to the present invention, the viscosity of functional ink is adjusted in addition to the shape and pitch of an uneven structure, thereby enabling liquid functional printing of 100 nm or less, and therefore it can be expected that the present invention is widely employed in development of various fields such as printed electronics, organic electronics, an electrode wiring technique such as a solar battery or a touch panel, and the like.

## Claims

1. A surface structure for a base material to be printed, wherein an uneven structure is formed on a surface of the base material to be printed to which ink is applied, and the pitch, the shape in plan view, and the depth of recesses in the uneven structure are determined on the basis of the physical properties (specific weight, viscosity, and contact angle) of ink to be used, in accordance with a printing pattern and a required printing precision, so that the amount of ink filling the recesses is controlled.

2. The surface structure for the base material to be printed according to claim 1, wherein the base material to be printed is formed of thermoplastic resin or ultraviolet curable resin and an uneven structure formed on a mold is transferred to the base material to be printed.

3. The surface structure for the base material to be printed according to claim 1 or 2, wherein the base material to be printed is formed by stacking a water-repellent layer, a hydrophilic layer, and a base material in an arbitrary combination thereof.

4. The surface structure for the base material to be printed according to any one of claims 1 to 3, wherein alignment marks are provided to perform positioning to a surface printer.

5. A method for manufacturing the base material to be printed according claim 1, the method comprising:
a first step of positioning a substrate;
a second step of performing patterning, which is in the negative relationship of the uneven structure of the base material to be printed, on the surface of the substrate;
a third step of producing a mold by processing the substrate on the basis of the patterning;
a fourth step of applying a release agent such as a fluorine-based release agent on the surface of the mold;
a fifth step of pressing a thermoplastic resin sheet against the surface of the mold to transfer the uneven structure formed on the mold; and
a sixth step of peeling the thermoplastic resin sheet.
